# EUROPEAN PATENT APPLICATION

(11) **EP 4 087 125 A1**
(43) Date of publication of application: **09.11.2022**
(21) Application number: 20909087.7
(22) Date of filing: 06.05.2020
(51) Int. Cl.: H03H 3/007

(54) **SEMICONDUCTOR STRUCTURE WITH STACKED UNIT AND MANUFACTURING METHOD, AND ELECTRONIC DEVICE**

(30) Priority: 31.12.2019 CN 201911419075
(71) Applicant: Rofs Microsystem (Tianjin) Co., Ltd, Tianjin 300462 (CN)
(72) Inventor: WEN, Pan, Tianjin 300462 (CN); PANG, Wei, Tianjin 300072 (CN); ZHANG, Lanyue, Tianjin 300462 (CN); ZHANG, Wei, Tianjin 300462 (CN); ZHANG, Menglun, Tianjin 300072 (CN); YANG, Qingrui, Tianjin 300072 (CN)
(74) Representative: Ström & Gulliksson AB
(86) International application number: PCT/CN2020/088720
(87) International publication number: WO 2021/135011

(57) **Abstract**

The present disclosure relates to a semiconductor structure with stacked units, the semiconductor structure including at least two units stacked in the thickness direction of the semiconductor structure, wherein each unit comprises a substrate, and at least one of the at least two units is provided with a device on the substrate thereof; each unit further includes a plurality of conductive bumps arranged on the substrate; corresponding conductive bumps of two adjacent stacked units are opposite each other and are connected in a bonding manner; and a top substrate of the uppermost unit of the at least two stacked units and a bottom substrate of the lowermost unit thereof form an encapsulation layer of the semiconductor structure. The present disclosure further relates to a manufacturing method for the semiconductor structure with stacked units, and an electronic device with the structure.

## Description

### TECHNICAL FIELD

Embodiments of the present disclosure relate to the field of semiconductors, and in particular, to a semiconductor structure with stacked units and a manufacturing method thereof, and an electronic apparatus having the semiconductor structure.

### BACKGROUND

With rapid development of wireless communication technologies and increasingly extensive application of miniaturized portable terminal apparatus, demand for highperformance and small-size RF front-end modules and devices is increasingly urgent.

A Micro-Electro-Mechanical System (MEMS) is involved in various fields such as electronics, machinery, materials, biology, medicine, etc., and has broad application prospect. In fields of electronic consumption and intelligent terminals, it is required to further reduce a size and cost of the MEMS, and integration of the MEMS is increasingly higher.

As an important device of the MEMS, a FBAR (Film Bulk Acoustic Resonator) filter has assumed an important position in a field of RF front-ends. With development of radio frequency communication, more and more FBARs are used in consumer electronic products such as mobile phones, with larger and larger area proportion. Therefore, it is placed ever greater demands on area reduction of the FBAR filter.

A traditional FBAR filter needs to be sealed by bonding a capping layer above a device substrate, in which the capping layer is another substrate, so as to prevent water vapor from entering the device and causing performance of the device to greatly degrade. Electrical behavior of the device is transferred to a metal pad on a back of the capping layer through a conductive through hole.

However, there is still a need in the prior art to further reduce packaging cost and filter volume of the traditional FBAR filter.

### SUMMARY

In order to alleviate or solve at least one aspect of the above problems in the related art, the present disclosure is proposed.

According to an aspect of embodiments of the present disclosure, there is provided a semiconductor structure with stacked units that includes at least two units stacked in a thickness direction of the semiconductor structure. Each of the at least two units includes a substrate, and the substrate of at least one unit of the at least two units is provided with a device. Each of the at least two units further includes a plurality of conductive protrusions arranged on the substrate. Conductive protrusions of two adjacent stacked units of the at least two units are opposite and bonded to each other. A top substrate of an uppermost unit of the at least two units and a bottom substrate of a lowermost unit of the at least two units are both packaging layers of the semiconductor structure.

Optionally, the semiconductor structure further includes a plurality of conductive through holes, and each of the plurality of conductive through holes at least passes through a substrate of one of the two adjacent stacked units to be electrically connected to one of the plurality of conductive protrusions.

An embodiment of the present disclosure also relates to a method of manufacturing a semiconductor structure with stacked units. The semiconductor structure includes at least two units stacked in a thickness direction of the semiconductor structure. The method includes: providing a first unit including a first substrate, the first substrate being provided with a plurality of first conductive protrusions at a first side thereof; providing a second unit including a second substrate, the second substrate being provided with a plurality of second conductive protrusions at a first side thereof; and oppositely stacking the first unit and the second unit in such a manner that each of the plurality of first conductive protrusions is opposite and bonded to one of the plurality of second conductive protrusions. A top substrate of an uppermost unit of the at least two units and a bottom substrate of a lowermost unit of the at least two units are both packaging layers of the semiconductor structure.

An embodiment of the present disclosure further relates to an electronic apparatus having the above semiconductor structure.

### BRIEF DESCRIPTION OF DRAWINGS

The following description and drawings can facilitate to understand these and other features and advantages in various embodiments disclosed in the present disclosure. The same reference signs in the drawings always indicate the same components.
FIGS. 1A to 1D are schematic sectional views illustratively showing a manufacturing process of a semiconductor structure with two stacked units according to an exemplary embodiment of the present disclosure, in which a concave-convex structure is provided on a conductive protrusion of a lower substrate.
FIGS. 2A to 2D are schematic sectional views illustratively showing a manufacturing process of a semiconductor structure with two stacked units according to an exemplary embodiment of the present disclosure, in which a concave-convex structure is provided on a conductive protrusion of an upper substrate.
FIGS. 3A to 3G are schematic sectional views illustratively showing a manufacturing process of a semiconductor structure with three stacked units according to an exemplary embodiment of the present disclosure.
FIG. 4A is a schematic sectional view illustratively showing a semiconductor structure with two stacked units according to an exemplary embodiment of the present disclosure, in which no concave-convex structure is provided on protrusions of an upper substrate and a lower substrate.
FIG. 4B is a schematic sectional view illustratively showing a semiconductor structure with three stacked units according to an exemplary embodiment of the present disclosure, in which no concave-convex structure is provided on protrusions of the three stacked units.
FIGS. 5A to 5E are schematic sectional views illustratively showing a manufacturing process of a semiconductor structure with four stacked units according to an exemplary embodiment of the present disclosure.
FIG. 6A is a schematic view illustratively showing a concave-convex or toothed slot structure provided on a substrate, FIG. 6B is a schematic view illustratively showing conductive protrusions provided on the substrate shown in FIG. 6A to cooperate with the concave-convex or toothed slot structure, and FIG. 6C is a schematic view illustratively showing a bonding connection between two units, in which the structure in FIG. 6B is illustrated.

### DESCRIPTION OF EMBODIMENTS

The technical solutions of the present disclosure will be further described below in detail through embodiments and in conjunction with the drawings. The same or similar reference signs indicate the same or similar components throughout the description. The following description of embodiments of the present disclosure with reference to the drawings is intended to explain the general inventive concept of the present disclosure, and should not be construed as a limitation to the present disclosure.

In the present disclosure, the semiconductor structure is illustrated by taking an acoustic wave filter as an example. The acoustic wave filter can be electrically connected in a vertical direction in a multi-substrate manner, which can reduce an area of a device, such as a filter, by more than 30%. In the present disclosure, for example, two stacked units are directly bonded to each other, and the top substrate of the upper unit and the bottom substrate of the lower unit both form the packaging layer of the semiconductor structure. In this way, the manufacturing process of two capping layers can be removed.

Compared with the solution of the device including a substrate and a capping layer, an electrical connection length between two devices (for example, filters) is substantially reduced in the technical solution of the present disclosure. Further, an electrical connection path sequentially passing through a device, a protrusion, a capping layer, PCB wirings, another capping layer, and another protrusion to another device is shorten to be a path sequentially passing through a device and a protrusion to another device, thereby greatly reducing circuit parasitism and improving electrical performance of the whole chip, especially insertion loss and echo reflection.

In addition, in the related art, the capping layer mainly functions to package and has no device function except for electrical connection. However, in the present disclosure, the second device substrate not only functions to package, but also has a device function (i.e., filtering ability). Compared with the two technologies, when a same function, for example a Tx function of a transmitting filter and an Rx function of a receiving filter, is achieved, a chip volume in the technical solution of the present disclosure is more than half of that of a traditional technology, the manufacturing cost can be reduced to nearly half of that of the traditional technology, and the electrical performance of the whole chip is improved.

In addition, there are various traditional manufacturing processes for the capping layer depending on the device substrate. However, in the present disclosure, similar processing technologies can be adopted for multiple device substrates and their processing platforms and equipment can be shared, and thus complexity of a whole process chain can be simplified and utilization rate of a single-step process can be improved, thus reducing manufacturing cost and improving manufacturing yield.

In addition, in the traditional manufacturing of the capping layer, substrate materials are removed generally from a cap without a device thereon to form a cavity structure, which can accommodate a device on the device substrate in a manufacturing manner of material saving. However, in the present disclosure, it is required to form a cavity structure on the substrate surface where the device is located. At this time, the cavity cannot be formed by removing the substrate materials, and the protrusion structure in a manufacturing manner of adding materials in this disclosure should be adopted to realize a sealing side wall of the cavity structure and leading of electrical connections. The protrusion structure is made of a metal material. That is, a metal protrusion bonded between adjacent substrates can have two functions, one is to ensure electrical connections (such as electrical connections between conductive protrusions in the figures), and the other is to ensure sealing performance (such as a packaging ring structure shown in the figure).

In the semiconductor structure of the present disclosure as shown in the figures, upward surfaces of the substrates each are an upper surface, and downward surfaces of the substrate each are a lower surface.

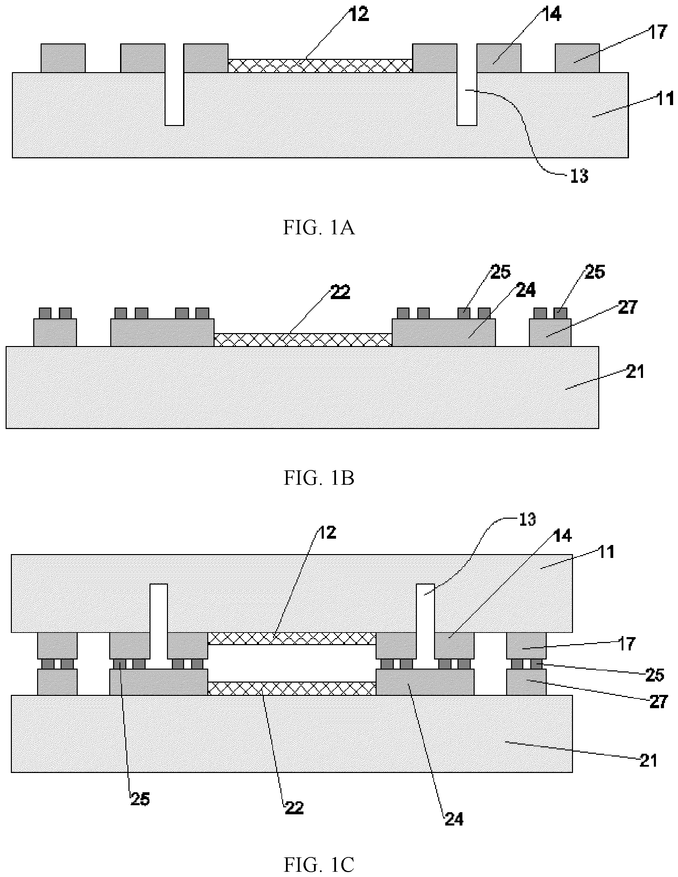

FIGS. 1A to 1D are schematic sectional views illustratively showing a manufacturing process of a semiconductor structure with two stacked units according to an exemplary embodiment of the present disclosure, in which a concave-convex or toothed slot structure is provided on a conductive protrusion of a lower substrate. In FIGS. 1A to ID, components indicated by respective reference numerals are as follows.

11: First substrate, which may be made of a material such as monocrystalline silicon, gallium arsenide, sapphire, and quartz.

21: Second substrate, which may be made of a material such as monocrystalline silicon, gallium arsenide, sapphire, and quartz.

12: First device, which for example is an electrical connection structure of an acoustic wave resonator or a plurality of acoustic wave resonators provided on an upper surface of the first substrate. The acoustic wave resonator includes, but is not limited to, an acoustic mirror, which may be a cavity, or may employ a Bragg reflection layer or other equivalent forms; a top electrode (an electrode pin), which can be made of a material such as molybdenum, ruthenium, gold, aluminum, magnesium, tungsten, copper, titanium, iridium, osmium, chromium, or composites or alloys thereof; a piezoelectric film layer, which may be made of a material such as aluminum nitride, zinc oxide, and PZT and contain the above materials doped with a certain atomic ratio of rare earth element; a top electrode (an electrode pin), which may be made of a material such as molybdenum, ruthenium, gold, aluminum, magnesium, tungsten, copper, titanium, iridium, osmium, chromium, or composites or alloys thereof.

22: Second device, which for example is an electrical connection structure of an acoustic wave resonator or a plurality of acoustic wave resonators provided on an upper surface of the second substrate. The acoustic wave resonator includes, but is not limited to, an acoustic mirror, which may be a cavity, or may employ a Bragg reflection layer or other equivalent forms; a bottom electrode (an electrode pin), which can be made of a material such as molybdenum, ruthenium, gold, aluminum, magnesium, tungsten, copper, titanium, iridium, osmium, chromium, or composites or alloys thereof; a piezoelectric film layer, which may be made of a material such as aluminum nitride, zinc oxide, and PZT and contain the above materials doped with a certain atomic ratio of rare earth element; a top electrode (an electrode pin), which may be made of a material such as molybdenum, ruthenium, gold, aluminum, magnesium, tungsten, copper, titanium, iridium, osmium, chromium, or composites or alloys thereof.

13: Connection hole of the first substrate. As can be understood by those skilled in the art, conductive through holes may be formed after the connecting holes are filled with an electrical connection metal.

18: Connection metal, which may be a material such as molybdenum, ruthenium, gold, aluminum, magnesium, tungsten, copper, titanium, iridium, osmium, chromium, or composites or alloys thereof.

14: First conductive protrusions provided on a lower surface of the first substrate, which are made of a bonding metal that may be a material such as molybdenum, ruthenium, gold, aluminum, magnesium, tungsten, copper, titanium, iridium, osmium, chromium, or composites or alloys thereof.

24: Second conductive protrusions provided on an upper surface of the second substrate, which are made of a bonding metal that may be a material such as molybdenum, ruthenium, gold, aluminum, magnesium, tungsten, copper, titanium, iridium, osmium, chromium, or composites or alloys thereof.

25: Concave-convex structure provided on the second conductive protrusion. In the present disclosure, the concave-convex structure refers to a protrusion or recess formed on a bonding end face or the protrusion and the recess formed on the bonding end face. Obviously, the concave-convex structure is made of a conductive material, and in an embodiment, it can be directly formed on the bonding end face by etching or the like.

16: Conductive pad, which may be made of a material such as molybdenum, ruthenium, gold, aluminum, magnesium, tungsten, copper, titanium, iridium, osmium, chromium, or composites or alloys thereof.

17: First sealing protrusion, which is made of a bonding metal that may be a material such as molybdenum, ruthenium, gold, aluminum, magnesium, tungsten, copper, titanium, iridium, osmium, chromium, or composites or alloys thereof.

27: Second sealing protrusion, which is made of a bonding metal that may be a material such as molybdenum, ruthenium, gold, aluminum, magnesium, tungsten, copper, titanium, iridium, osmium, chromium, or composites or alloys thereof. The first sealing protrusion and the second sealing protrusion are bonded to each other to form a sealing ring structure.

In an embodiment, the protrusions are made of the same material.

In addition, description of materials of respective components in the above embodiment is also applicable to other embodiments.

In FIG. ID, a conductive through hole 13 passes through the first substrate 11 and the first conductive protrusion 14 to be electrically connected to the second conductive protrusion 24 on the second substrate 21.

As shown in FIG. ID, when the first substrate 11 and the second substrate 21 are stacked, the corresponding bonding structures or protrusions are bonded to each other.

As shown in FIG. ID, an upper end of the conductive through hole 13 is opened or located on an upper surface of the first substrate 11. As shown in FIG. ID, the conductive pad 16 is arranged on the upper surface of the first substrate 11 and electrically connected to the upper end of the connection metal 18.

In the structure shown in FIG. ID, the sealing ring structure, the first substrate that is configured to be a packaging layer and the second substrate that is configured to be a packaging layer form a sealing structure or packaging structure of the semiconductor structure. In this way, the process of forming two capping layers are removed.

A manufacturing process of a semiconductor structure with two stacked units according to an exemplary embodiment of the present disclosure is exemplarily described referring to FIGS. 1A to 1D below.

As shown in FIG. 1A, a first unit is provided. The first unit includes a first substrate 11, and a first device 12 and a plurality of first conductive protrusions 14 electrically connected with the first device 12 are provided on a first side (i.e., an upper side in FIG. 1A) of the first substrate 11. A protruding height of each of the plurality of first conductive protrusions 14 is greater than a thickness of the first device 12. In addition, the first unit includes the first holes 13 that pass through the plurality of first conductive protrusion 14 in one-to-one correspondence and entry partially into the first substrate 11. In an embodiment, the first device 12 may not be provided so that the protruding height of the plurality of first conductive protrusions 14 is unnecessary to be higher than the thickness of the first device 12.

As shown in FIG. 1B, a second unit is provided. The second unit includes a second substrate 21, and a second device 22 and a plurality of second conductive protrusions 24 electrically connected with the second device 22 are provided on a first side (i.e., an upper side in FIG. 1B) of the second substrate 21. A protruding height of each of the plurality of second conductive protrusions 24 is greater than a thickness of the second device 22. In addition, as shown in FIG. 1B, the concave-convex structure 25 is arranged on the second conductive protrusion 24.

As shown in FIG. 1C, the first unit and the second unit are oppositely stacked so that the corresponding conductive protrusions 14 and 24 of the two units are opposite and bonded to each other.

As shown in FIG. ID, the first substrate 11 is thinned, that is, the first substrate 11 is thinned from its second side (i.e., an upper side of the first substrate 11 in FIG. ID) to expose the first holes 13. A conductive through hole is formed by filling the first hole 13 with the connecting metal 18. As shown in FIG. ID, the conductive pad 16 is formed and electrically connected to the conductive through hole.

It should be noted that, in an embodiment, the first hole 13 is firstly covered by the conductive pad 16, then etching is performed to make the first hole 13 extend through the conductive pad. After that, the first hole 13 is filled with the conductive material to form the conductive through hole. Alternatively, the first hole 13 is filled with the conductive material to form the conductive through hole, and then the conductive pad covers a respective conductive through hole to be electrically connected with the conductive through hole.

As shown in FIGS. 1A to ID, the first substrate and the second substrate are provided with first sealing protrusions 17 and second sealing protrusions 27, respectively. The protrusions can have the same structure and thickness as the conductive protrusions arranged in a same layer, or can be made of a same material as the conductive protrusions arranged in a same layer, so that they can be formed in one processing step with the conductive protrusions of the same layer. However, in the present disclosure, the first sealing protrusions and the second sealing protrusions may be formed in another step.

Based on the method shown in FIGS. 1A to ID, the sealing ring structure, the first substrate as the packaging layer and the second substrate that are configured to be the packaging layer form the sealing structure or packaging structure of the semiconductor structure, thereby removing a manufacturing step of two capping layers.

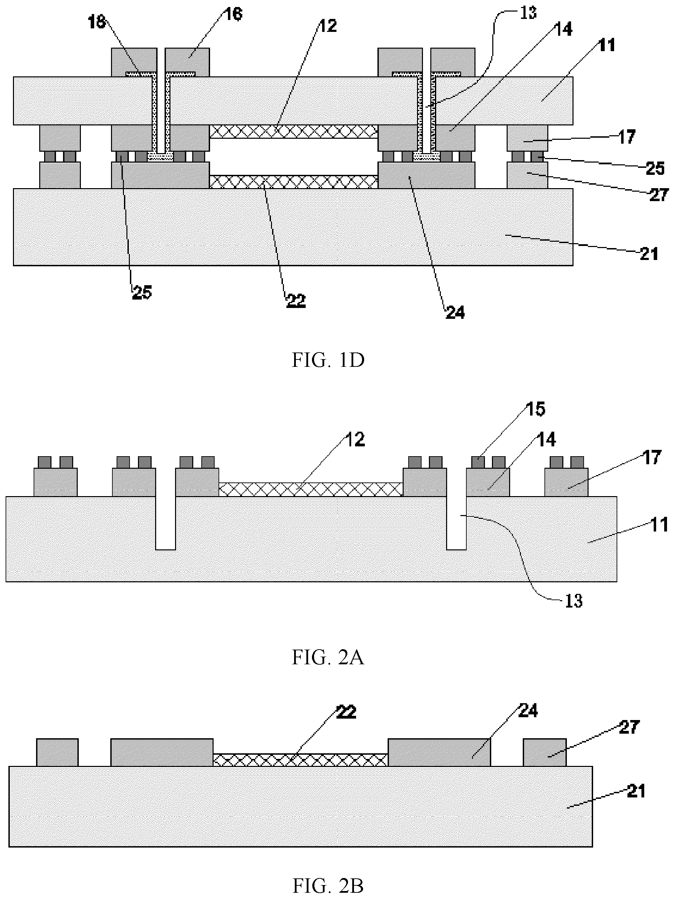

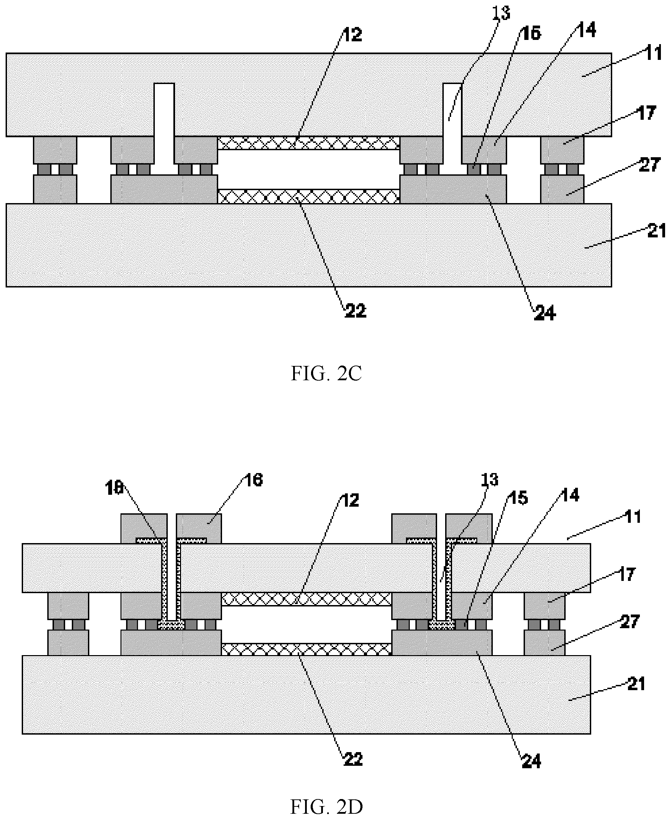

FIGS. 2A to 2D are schematic sectional views illustratively showing a manufacturing process of a semiconductor structure with two stacked units according to an exemplary embodiment of the present disclosure, in which a concave-convex structure is provided on a conductive protrusion of an upper substrate. In FIGS. 2A to 2D, unlike FIGS. 1A to 1D in which a bonding end face of the second conductive protrusion 24 is provided with a concave-convex structure 25, a bonding end face of each of the plurality of first conductive protrusions 14 is provided with a concave-convex structure 15.

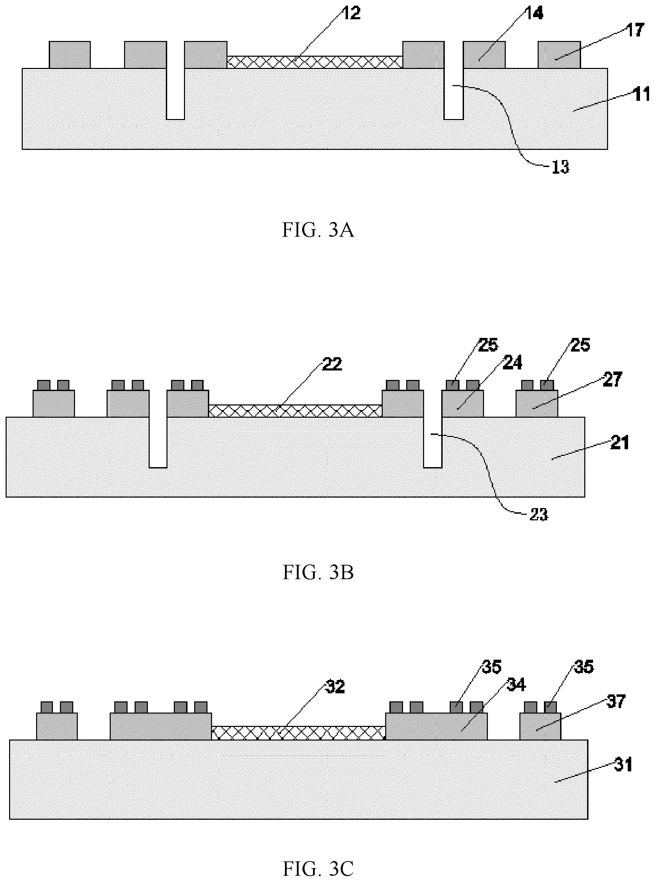

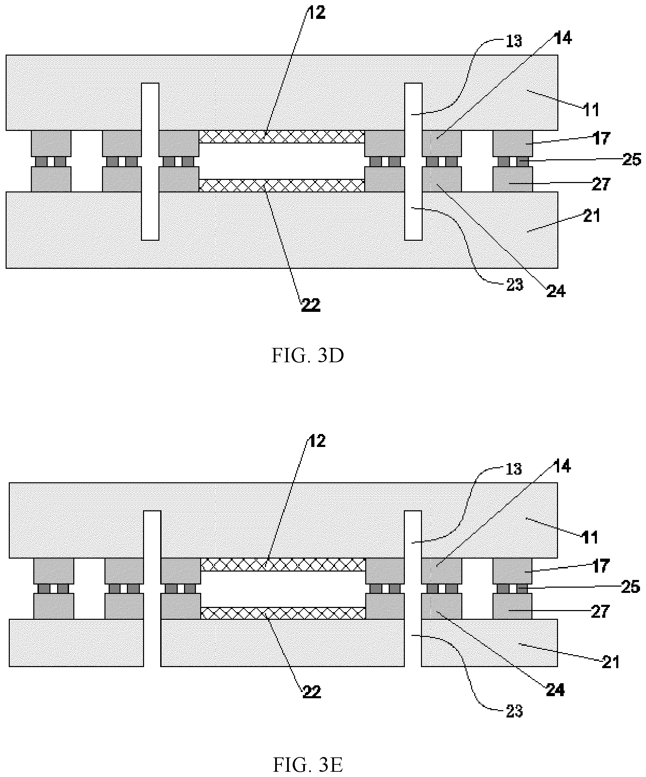

FIGS. 3A to 3D are schematic sectional views illustratively showing a manufacturing process of a semiconductor structure with three stacked units according to an exemplary embodiment of the present disclosure. The manufacturing steps shown in FIGS. 3A to 3F are different from those in FIGS. 1A to 1D in that a third unit is added.

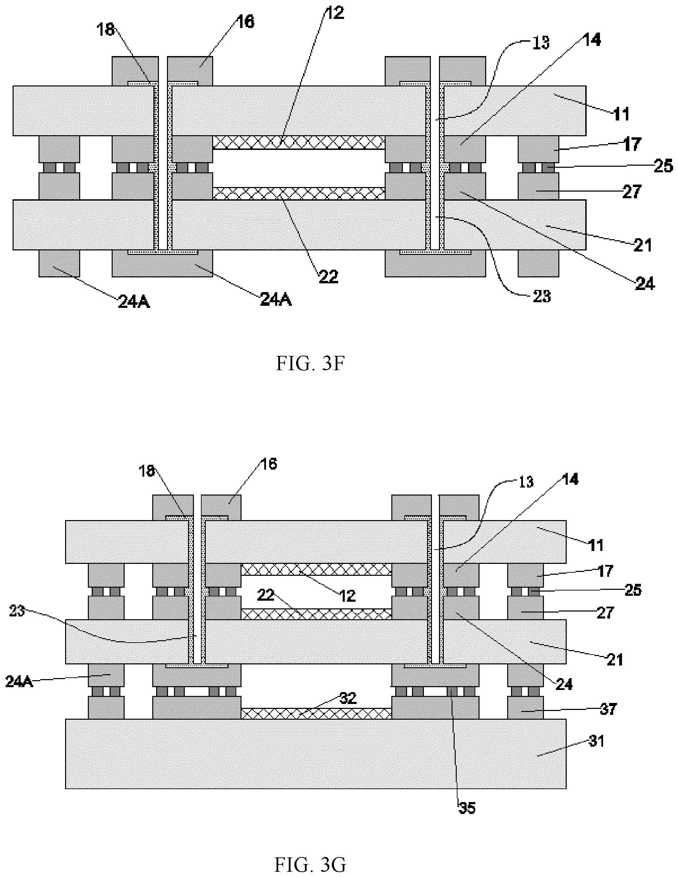

Specifically, in FIGS. 3A to 3G, a step of "providing the second unit" includes providing second holes 23, and each of the second holes passes through one of the second conductive protrusions and enters partially into the second substrate, as shown in FIG. 3B. In a step of "oppositely stacking the first unit and the second unit", the first hole 13 is aligned with the second hole 23, for example as shown in FIG. 3G.

In addition, the method further includes following steps.

Referring to FIG. 3E, the second substrate 21 is thinned, that is, the second substrate 21 is thinned from a second side of the second substrate 21 to expose the second holes 23.

Referring to FIG. 3F, a plurality of upper conductive protrusions 24A are provided on the second side of the second substrate 21 at positions in a thickness direction corresponding to the second conductive protrusions 24. An axis of each of the conductive through holes (the conductive through holes are formed by filling the first holes and the second holes with the conductive materials) passes through a corresponding one upper conductive protrusion of the plurality of upper conductive protrusions 24A, and the one upper conductive protrusion 24A is configured to be electrically connected to the conductive through hole.

Referring to FIG. 3C, a third unit is provided and includes a third substrate 31. The third substrate 31 is provided with a third device 32 and a plurality of third conductive protrusions 34 electrically connected with the third device on a first side thereof. A protruding height of each of the plurality of third conductive protrusion 34 is greater than a thickness of the third device 32, and the third conductive protrusion 34 is a lower conductive protrusion. In FIG. 3C, optionally, the bonding end face of the third conductive protrusion 34 is provided with a concave-convex structure 35. Alternatively, the third device 32 may not be provided so that the protruding height of the third conductive protrusion is unnecessary to be higher than the thickness of the third device.

Referring to FIG. 3G, the third unit and the second unit are oppositely stacked so that each of the upper conductive protrusions 24Ais opposite and bonded to one of the concave-convex structures 35.

As shown in FIGS. 3C, 3E to 3G, a sealing ring structure formed by the second sealing protrusion 27A and the third sealing protrusion 37 is also provided between the second substrate and the third substrate. This seal ring structure may be the same as the above seal ring structure.

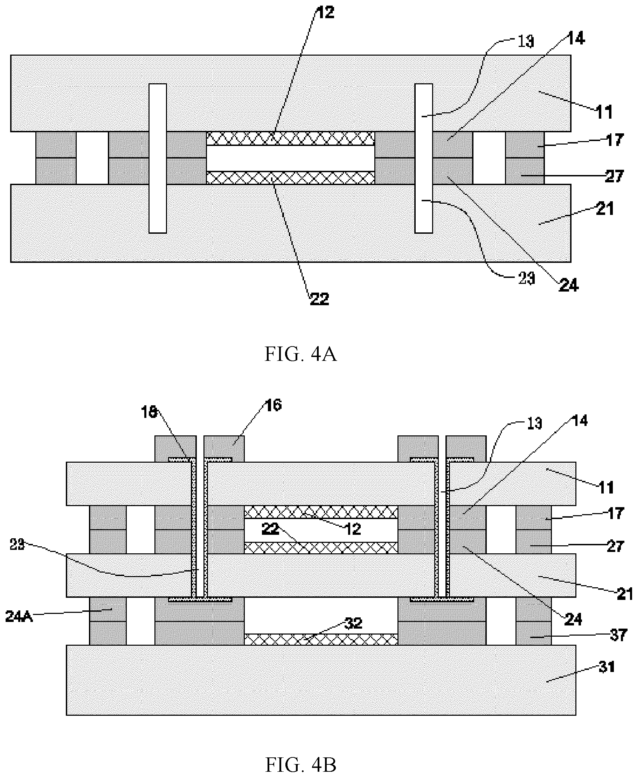

FIG. 4A is a schematic sectional view illustratively showing a semiconductor structure with two stacked units according to an exemplary embodiment of the present disclosure, in which unlike FIGS. 1D and 2D, no concave-convex structure is provided on protrusions of the upper substrate and the lower substrate.

FIG. 4B is a schematic sectional view illustratively showing a semiconductor structure with three stacked units according to an exemplary embodiment of the present disclosure, in which unlike FIG. 3G, no concave-convex structure is provided on protrusions.

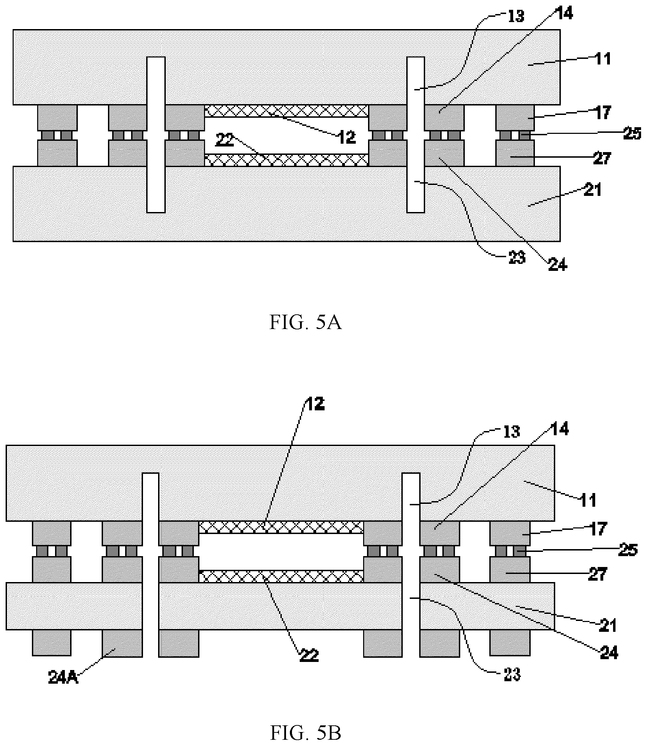

FIGS. 5A to 5E are schematic sectional views illustrating a manufacturing process of a semiconductor structure with four stacked units according to an exemplary embodiment of the present disclosure. The manufacturing steps shown in FIGS. 5A to 5E are different from those in FIGS. 1A to 1D in that a third unit and a fourth unit are provided.

Specifically, in FIGS. 5A to 5E, a step of "providing the second unit" includes providing second holes 23, and each of the second holes passes through one of the second conductive protrusions and enters partially into the second substrate, as shown in FIG. 5A. In a step of "oppositely stacking the first unit and the second unit", the first hole 13 is aligned with the second hole 23, for example as shown in FIG. 5A.

In addition, the method further includes following steps.

Referring to FIG. 5B, the second substrate 21 is thinned, that is, the second substrate 21 is thinned from a second side of the second substrate 21 to expose the second holes 23.

Referring to FIG. 5B, a plurality of upper conductive protrusions 24A are provided on the second side of the second substrate 21 at positions in a thickness direction corresponding to the second conductive protrusions 24. An axis of each of the conductive through holes (the conductive through holes are formed by filling the first holes and the second holes with the conductive materials) passes through a corresponding one upper conductive protrusion of the plurality of upper conductive protrusions 24A, and the one upper conductive protrusion 24A is configured to be electrically connected to the conductive through hole.

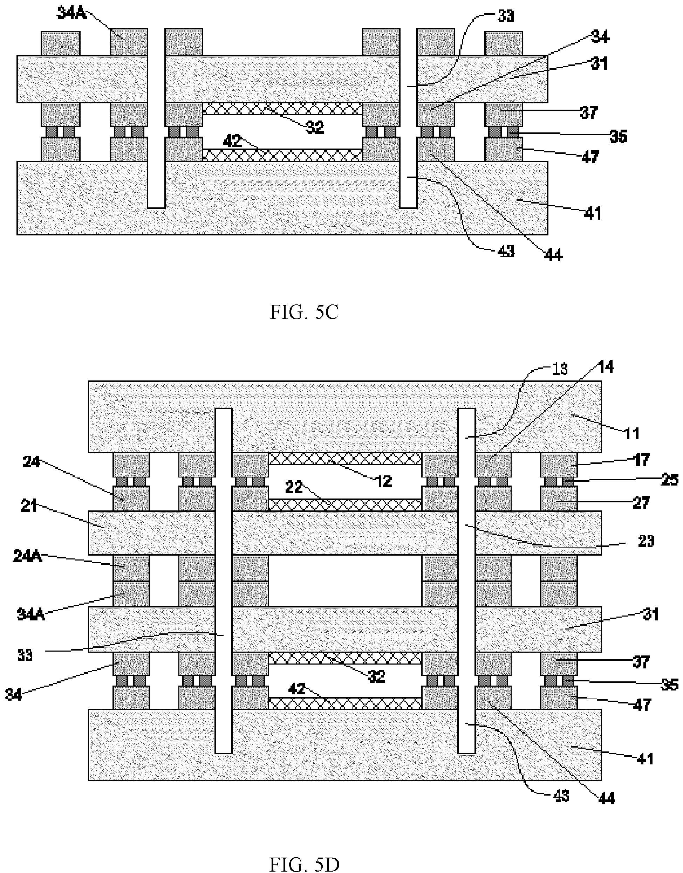

An additional set of units are provided, and at least include a third unit and a fourth unit, as shown in FIG. 5C.

The third unit includes the third substrate 31. The third substrate 31 is provided with the third device 32, and a plurality of third conductive protrusions 34 and 34A are provided on upper and lower sides of the third substrate. The third conductive protrusions 34 arranged on the same side as the third device 32 are electrically connected with the third device, and has a protruding height greater than the thickness of the third device 32. The third unit includes third holes 33. The third holes 33 pass through the third substrate 31 and the third conductive protrusions 34A on the upper side of the third substrate to reach or at least partially pass through the third conductive protrusions 34 on the lower side of the third substrate. The third conductive protrusions 34A located on the upper side of the third substrate are the lower conductive protrusions. Obviously, each of the third holes 33 is aligned and communicated with one of the first holes 13 and one of the second holes 23. Alternatively, the third device 32 may not be provided so that the protruding height of the third conductive protrusion is unnecessary to be higher than the thickness of the third device.

The fourth unit includes a fourth substrate 41, and is provided with a fourth device 42 and a plurality of fourth conductive protrusions 44 electrically connected with the fourth device on a first side thereof. The fourth conductive protrusions 44 have a protruding height greater than a thickness of the fourth device 42. Alternatively, the fourth device 42 may not be provided so that the protruding height of the fourth conductive protrusions 44 is unnecessary to be higher than the thickness of the fourth device.

The third unit and the fourth unit are oppositely stacked, and each of the fourth conductive protrusions 44 is stacked oppositely to and bonded to a corresponding one of the third conductive protrusions 34.

As shown in FIG. 5D, the additional unit and the second unit are oppositely stacked, so that the upper conductive protrusion 24A and the corresponding lower conductive protrusion 34A are opposite and bonded to each other.

In a further embodiment, as shown in FIG. 5D, the fourth unit includes fourth holes 43 at least passing through the fourth conductive protrusions. The oppositely stacking the additional unit and the second unit further includes aligning and communicating the first hole with the fourth hole.

As shown in FIG. 5D, a sealing ring structure formed by the second sealing protrusion 27A and the third sealing protrusion 37A is also provided between the second substrate and the third substrate, and a sealing ring structure formed by the third sealing protrusion 37 and a fourth sealing protrusion 47 is also provided between the third substrate and the fourth substrate. These seal ring structures may be the same as the above seal ring structure.

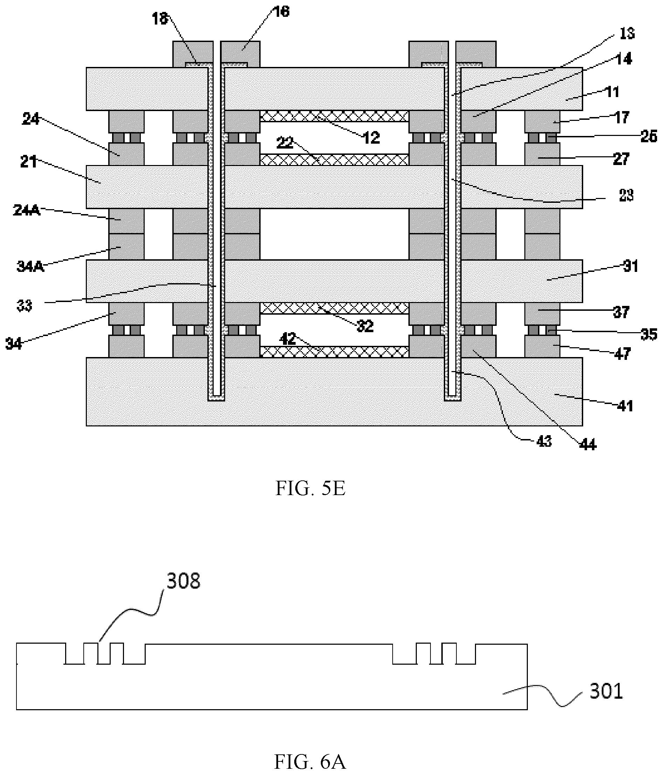

As shown in FIG. 5E, the first substrate 11 is thinned, that is, the first substrate 11 is thinned from its second side (i.e., an upper side of the first substrate 11 in FIG. 5E) to expose the first holes 13. A conductive through hole is formed by filling the first hole 13 with the connecting metal 18. As shown in FIG. 5E, the conductive pad 16 is formed and electrically connected to the conductive through hole.

FIG. 6A is a schematic view illustratively showing a concave-convex or toothed slot structure provided on a substrate, and as shown in FIG. 6A, the concave-convex or toothed slot structure 308 is provided on the substrate 301. The structure 308 can be obtained by etching.

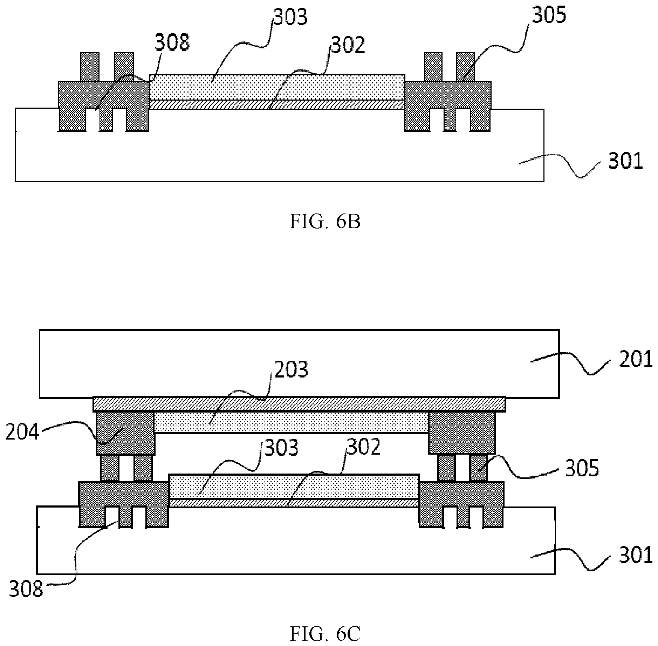

FIG. 6B is a schematic view illustratively showing a conductive protrusion provided on the substrate shown in FIG. 6A to cooperate with the concave-convex or toothed slot structure, and FIG. 6B can be regarded as an alternative to FIG. IB. In FIG. 6B, a substrate is indicated by 301, a supporting layer is indicated by 302, a device is indicated by 303, a concave-convex or toothed slot structure is indicated by 308, and a conductive protrusion is indicated by 305.

FIG. 6C is a schematic view illustratively showing a bonding connection between two units based on the structure in FIG. 6B. FIG. 6C can be regarded as an alternative embodiment to FIG. 1C. As shown in FIG. 6C, an upper unit includes a substrate 201, a device 203, and conductive protrusions 204. A lower unit includes a substrate 301, a concave-convex or toothed slot structure 308, a device 303, and a supporting layer 302. The two devices are bonded to each other to provide protection between the two devices.

An end face of at least one of the upper protrusion and the lower protrusion that are oppositely aligned with and bonded to each other is provided with a concave-convex structure, or neither of them is provided with the concave-convex structure.

A number of stacked units is not limited to 2, 3, and 4, but can be more.

In view of the above, the present disclosure provides following technical solutions.
1. A semiconductor structure with stacked units includes at least two units stacked in a thickness direction of the semiconductor structure, wherein:
   each of the at least two units includes a substrate, and the substrate of at least one unit of the at least two units is provided with a device;
   the substrate of each of the at least two units further is provided with a plurality of conductive protrusions;
   conductive protrusions of two adjacent stacked units of the at least two units are opposite and bonded to each other; and
   a top substrate of an uppermost unit of the at least two units and a bottom substrate of a lowermost unit of the at least two units are both packaging layers of the semiconductor structure.
2. The semiconductor structure according to 1, wherein
   the semiconductor structure further includes a plurality of conductive through holes, and each of the plurality of conductive through holes at least passes through a substrate of one of the two adjacent stacked units to be electrically connected to one of the plurality of conductive protrusions.
3. The semiconductor structure according to 2, wherein
   the plurality of conductive through holes each have an upper end, and the upper end is opened on an upper surface of the top substrate of the uppermost unit.
4. The semiconductor structure according to 3, wherein
   the at least two units include a first unit and a second unit that are stacked in the thickness direction of the semiconductor structure, and the first unit is arranged above the second unit;
   the first unit includes a first substrate and a plurality of first conductive protrusions protruding from a lower surface of the first substrate;
   the second unit includes a second substrate and a plurality of second conductive protrusions protruding from an upper surface of the second substrate;
   each of the plurality of first conductive protrusions is oppositely aligned with and bonded to one of the plurality of second conductive protrusions, and the lower surface of the first substrate and the upper surface of the second substrate form a first accommodation space therebetween;
   each of the plurality of conductive through holes passes through the first substrate and one of the plurality of first conductive protrusions, and is electrically connected to one of the plurality of conductive protrusions arranged on the upper surface of the first substrate; and
   at least one of the lower surface of the first substrate and the upper surface of the second substrate is provided with a device, the plurality of conductive protrusions have a protruding height protruding from a surface where the device is located, the protruding height is greater than a thickness of the device, and the device is located in the first accommodating space.
5. The semiconductor structure according to 4, wherein
   the semiconductor structure further includes a third unit, and the third unit includes a third substrate and third conductive protrusions protruding from an upper surface of the third substrate;
   the second substrate is provided with lower conductive protrusions at a lower surface thereof;
   each of the third conductive protrusions is oppositely aligned with and bonded to one of the lower conductive protrusions, and the lower surface of the second substrate and the upper surface of the third substrate form a second accommodation space therebetween;
   the plurality of conductive through holes extends through the second substrate, and each of the plurality of conductive through holes is electrically connected to one of the lower conductive protrusions; and
   at least one of the lower surface of the second substrate and the upper surface of the third substrate is provided with an additional device, the plurality of conductive protrusions have a protruding height protruding from a surface where the additional device is located, the protruding height is greater than a thickness of a corresponding one of the devices, and the additional device is located in the second accommodating space.
6. The semiconductor structure according to 4, wherein
   the first unit and the second unit form a first set of units;
   the semiconductor structure further includes a second set of units, and the second set of units are located below the first set of units in the thickness direction of the semiconductor structure;
   the second set of units include a third unit and a fourth unit, and the first unit, the second unit, the third unit and the fourth unit are sequentially stacked from top to bottom in the thickness direction of the semiconductor structure;
   the third unit includes a third substrate and a plurality of third conductive protrusions protruding from a lower surface of the third substrate;
   the fourth unit includes a fourth substrate and a plurality of fourth conductive protrusions protruding from an upper surface of the fourth substrate;
   the lower surface of the second substrate is provided with lower conductive protrusions protruding from the lower surface of the second substrate, an upper surface of the third substrate is provided with upper conductive protrusions protruding from the upper surface of the third substrate, each of the lower conductive protrusions is oppositely aligned with and bonded to one of the upper conductive protrusions, and the lower surface of the third substrate and the upper surface of the fourth substrate form a third accommodating space therebetween;
   each of the plurality of conductive holes passes through the first substrate, one of the plurality of first conductive protrusions, one of the plurality of second conductive protrusions, the second substrate, one of the lower conductive protrusions, one of the upper conductive protrusions, and the third substrate, and is electrically connected to one of the plurality of third conductive protrusions; and
   at least one of the lower surface of the third substrate and the upper surface of the fourth substrate is provided with an additional device, the plurality of conductive protrusions have a protruding height protruding from a surface where the additional device is located, the protruding height is greater than a thickness of a corresponding one of the devices, and the additional device is located in the third accommodating space.
7. The semiconductor structure according to 3, wherein
   at least one of the plurality of conductive through holes is electrically connected to a conductive pad on the upper surface of the top substrate of the uppermost unit.
8. The semiconductor structure according to any one of 3 to 7, wherein
   at least one of the plurality of conductive through holes extends through the top substrate of the uppermost unit from top to bottom, and is electrically connected to the conductive protrusions of the lowermost unit.
9. The semiconductor structure according to 1, wherein
   at least one conductive protrusion of the two conductive protrusions that are oppositely aligned with and bonded to each other has an end face, and the end face of the at least one conductive protrusion is provided with a concave-convex structure.
10. The semiconductor structure according to any one of 3 to 8, wherein
   at least one conductive protrusion of the two conductive protrusions that are oppositely aligned with and bonded to each other has an end face, and the end face of the at least one conductive protrusion is provided with a concave-convex structure; and
   the concave-convex structure is arranged around a periphery of a corresponding one of the plurality of conductive through holes.
11. The semiconductor structure according to 1, wherein
   each of the conductive protrusions that are arranged on a same side of a same substrate as the device protrudes from a side of the substrate, and has a protruding height that is larger than a thickness of the device arranged on the side of the substrate.
12. The semiconductor structure according to any one of 1 to 11 further includes:
   a plurality of packaging rings, each of the plurality of packaging rings being arranged between two adjacent substrates, and being located at an outer side of all the plurality of conductive protrusions and spaced apart from the plurality of conductive protrusions.
13. The semiconductor structure according to 12, wherein
   the plurality of packaging rings each includes upper packaging protrusions and lower packaging protrusions that are metal-bonded to each other, the upper packaging protrusions are provided on a lower surface of an upper substrate of the two adjacent substrates, and the lower packaging protrusions are provided on an upper surface of a lower substrate of the two adjacent substrates.
14. The semiconductor structure according to 13, wherein
   the upper package protrusions and conductive protrusions arranged on the lower surface of the upper substrate are arranged in a same layer, are made of a same material, and have a same height; and
   the lower package protrusions and conductive protrusions arranged on the upper surface of the lower substrate are arranged in a same layer, is made of a same material, and have a same height.
15. The semiconductor structure according to 14, wherein
   an end face of at least one of the upper package protrusion and the lower package protrusion that are oppositely aligned with and bonded to each other is provided with a concave-convex structure.
16. The semiconductor structure according to 1, wherein
   the substrate of the at least one unit is provided with an toothed slot or concave-convex structure, and a lower side of the corresponding conductive protrusions matches with the toothed slot or concave-convex structure.
17. The semiconductor structure according to 1 or 16, wherein
   a bonding face of at least one of the two conductive protrusions that are opposite and bonded to each other is provided with an additional toothed slot or concave-convex structure.
18. The semiconductor structure according to 1, wherein
   the semiconductor structure is a film bulk acoustic wave resonator, a film bulk acoustic wave filter, a duplexer, or a quadplexer.
19. A method of manufacturing a semiconductor structure with stacked units, the semiconductor structure including at least two units stacked in a thickness direction of the semiconductor structure, wherein the method includes:
   providing a first unit including a first substrate, the first substrate being provided with a plurality of first conductive protrusions at a first side thereof;
   providing a second unit including a second substrate, the second substrate being provided with a plurality of second conductive protrusions at a first side thereof; and
   oppositely stacking the first unit and the second unit in such a manner that each of the plurality of first conductive protrusions is opposite and bonded to one of the plurality of second conductive protrusions,
   wherein
   a top substrate of an uppermost unit of the at least two units and a bottom substrate of a lowermost unit of the at least two units are both packaging layers of the semiconductor structure.
20. The method according to 19, wherein
   the step of "providing the first unit" includes providing first holes, each of the first holes passes through one of the plurality of first conductive protrusions and enters partially into the first substrate; and
   the method further includes:
      thinning the first substrate, that is, thinning the first substrate from a second side of the first substrate to expose the first holes; and
      forming conductive through holes by filling the first holes with a conductive material.
21. The method according to 20, wherein
   the method includes: forming conductive pads on the second side of the thinned first substrate, the conductive pads being arranged in one-to-one correspondence with the first holes, and each of the conductive pads being configured to be electrically connected to one of the conductive through holes.
22. The method according to 21, wherein
   the step of "forming the conductive pads" includes covering each of the conductive through holes with one conductive pad of the conductive pads in such a manner that the conductive through hole is electrically connected with the one conductive through hole.
23. The method according to any one of 20 to 22, wherein
   the step of "providing the second unit" includes providing second holes, each of the second holes passes through one of the plurality of second conductive protrusions and enters partially into the second substrate, and wherein, in the step of "oppositely stacking the first unit and the second unit", the first holes is aligned with the second holes in one-to-one correspondence; and
   the method further includes:
      thinning the second substrate, that is, thinning the second substrate from the second side of the second substrate to expose the second holes;
      providing a plurality of upper conductive protrusions on the second side of the second substrate at positions corresponding to the second conductive protrusions in a thickness direction, an axis of each of the conductive through holes passing through one upper conductive protrusion of the plurality of upper conductive protrusions, and the conductive through hole being configured to be electrically connected to the one upper conductive protrusion;
      providing an additional unit, the additional unit including an additional substrate, and the additional substrate being provided with a plurality of lower conductive protrusions at an upper side thereof; and
      oppositely stacking the additional unit and the second unit, in such a manner that each of the plurality of upper conductive protrusions is opposite and bonded to one of the plurality of lower conductive protrusions.
24. The method according to 23, wherein
   the "providing the additional unit" includes providing a third unit, the third unit includes a third substrate that is configured to be the additional substrate, and the third substrate is provided with a plurality of third conductive protrusions on a first side thereof.
25. The method according to 23, wherein
   the "providing the additional unit" includes providing an additional set of units, and the additional set of units at least include a third unit and a fourth unit, wherein
      the third unit includes a third substrate and third holes, upper and lower sides of the third substrate each are provided with a plurality of third conductive protrusions, each of the third holes passes through the third substrate and one of the plurality of third conductive protrusion arranged on the upper side of the third substrate to reach or at least partially pass through one of the plurality of third conductive protrusions arranged on the lower side of the third substrate, and the plurality of third conductive protrusions arranged on the upper side of the third substrate are the plurality of lower conductive protrusions;
      the fourth unit includes a fourth substrate, the fourth substrate is provide with a plurality of fourth conductive protrusions on a first side thereof, and the plurality of fourth conductive protrusions has a protruding height greater than a thickness of the fourth device; and
      the third unit and the fourth unit are oppositely stacked, and each of the plurality of fourth conductive protrusions is opposite and bonded to one of the plurality of third conductive protrusions that is arranged opposite to the fourth conductive protrusion; and
   the "oppositely stacking the additional unit and the second unit" further includes aligning and communicating the third holes with the first holes and the second holes in one-to-one correspondence.
26. The method according to 25, wherein
   the fourth unit includes fourth holes, and each of the fourth holes at least passes through one of the plurality of fourth conductive protrusions; and
   the "oppositely stacking the additional unit and the second unit" further includes aligning and communicating the first holes, the second holes, the third holes, and the fourth hole in one-to-one correspondence.
27. The method according to any one of 16 to 24 further includes:
   providing a plurality of packaging rings, each of the plurality of packaging rings being arranged between two adjacent substrates, being located at an outer side of all the conductive protrusions, and being spaced apart from a corresponding one of the conductive protrusions.
28. The method according to 27, wherein
   the plurality of packaging rings each includes an upper packaging protrusion and a lower packaging protrusion that are metal-bonded to each other, the upper packaging protrusion is arranged on a lower surface of an upper substrate of the two adjacent substrates, and the lower packaging protrusion is arranged on an upper surface of a lower substrate of the two adjacent substrates; and
   the conductive protrusions and the packaging protrusions of a same layer are formed simultaneously.
29. The method according to 28, wherein
   an end face of at least one of the upper protrusion and the lower protrusion that are oppositely aligned with and bonded to each other is provided with a concave-convex or toothed slot structure.
30. An electronic apparatus includes the semiconductor structure according to any one of 1 to 18 or the semiconductor structure manufactured by the method according to any one of 19 to 29.

In the present disclosure, the semiconductor structure may be a film bulk acoustic wave resonator, a film bulk acoustic wave filter, a duplexer, or a quadplexer. As can be understood, the semiconductor structure may be other structures based on different chips of units. In the present disclosure, the chip may include a semiconductor device, such as a microelectromechanical device, and an active or passive semiconductor device.

The electronic apparatus herein includes, but is not limited to, an intermediate product such as an RF front end, a filtering and amplifying module; and a terminal product such as a mobile phone, WIFI and a drone.

Although the embodiments of the present disclosure have been shown and described, it should be understood for those skilled in the art that modifications may be made to these embodiments without departing from the principle and spirit of the present disclosure, and the scope thereof is defined by the appended claims and their equivalents.

## Claims

1. A semiconductor structure with stacked units, comprising:
at least two units stacked in a thickness direction of the semiconductor structure,
wherein each of the at least two units comprises a substrate, and the substrate of at least one unit of the at least two units is provided with a device;
wherein the substrate of each of the at least two units further is provided with a plurality of conductive protrusions;
wherein conductive protrusions of two adjacent stacked units of the at least two units are opposite and bonded to each other; and
wherein a top substrate of an uppermost unit of the at least two units and a bottom substrate of a lowermost unit of the at least two units are both packaging layers of the semiconductor structure.

2. The semiconductor structure according to claim 1, further comprising:
a plurality of conductive through holes, each of the plurality of conductive through holes at least passing through a substrate of one of the two adjacent stacked units to be electrically connected to one of the plurality of conductive protrusions.

3. The semiconductor structure according to claim 2, wherein the plurality of conductive through holes each have an upper end, and the upper end is opened on an upper surface of the top substrate of the uppermost unit.

4. The semiconductor structure according to claim 3, wherein the at least two units comprise a first unit and a second unit that are stacked in the thickness direction of the semiconductor structure, and the first unit is arranged above the second unit;
the first unit comprises a first substrate and a plurality of first conductive protrusions protruding from a lower surface of the first substrate;
the second unit comprises a second substrate and a plurality of second conductive protrusions protruding from an upper surface of the second substrate;
each of the plurality of first conductive protrusions is oppositely aligned with and bonded to one of the plurality of second conductive protrusions, and the lower surface of the first substrate and the upper surface of the second substrate form a first accommodation space therebetween;
each of the plurality of conductive through holes passes through the first substrate and one of the plurality of first conductive protrusions, and is electrically connected to one of the plurality of conductive protrusions arranged on the upper surface of the first substrate; and
at least one of the lower surface of the first substrate and the upper surface of the second substrate is provided with a device, the plurality of conductive protrusions have a protruding height protruding from a surface where the device is located, the protruding height is greater than a thickness of the device, and the device is located in the first accommodating space.

5. The semiconductor structure according to claim 4, further comprising:
a third unit comprising a third substrate and third conductive protrusions protruding from an upper surface of the third substrate,
wherein the second substrate is provided with lower conductive protrusions at a lower surface thereof;
wherein each of the third conductive protrusions is oppositely aligned with and bonded to one of the lower conductive protrusions, and the lower surface of the second substrate and the upper surface of the third substrate form a second accommodation space therebetween;
wherein the plurality of conductive through holes extends through the second substrate, and each of the plurality of conductive through holes is electrically connected to one of the lower conductive protrusions; and
wherein at least one surface of the lower surface of the second substrate and the upper surface of the third substrate is provided with an additional device, the plurality of conductive protrusions have a protruding height protruding from a surface where the additional device is located, the protruding height is greater than a thickness of a corresponding one of the devices, and the additional device is located in the second accommodating space.

6. The semiconductor structure according to claim 4, wherein the first unit and the second unit form a first set of units;
the semiconductor structure further comprises a second set of units, and the second set of units are located below the first set of units in the thickness direction of the semiconductor structure;
the second set of units comprise a third unit and a fourth unit, and the first unit, the second unit, the third unit and the fourth unit are sequentially stacked from top to bottom in the thickness direction of the semiconductor structure;
the third unit comprises a third substrate and a plurality of third conductive protrusions protruding from a lower surface of the third substrate;
the fourth unit comprises a fourth substrate and a plurality of fourth conductive protrusions protruding from an upper surface of the fourth substrate;
the lower surface of the second substrate is provided with lower conductive protrusions protruding from the lower surface of the second substrate, an upper surface of the third substrate is provided with upper conductive protrusions protruding from the upper surface of the third substrate, each of the lower conductive protrusions is oppositely aligned with and bonded to one of the upper conductive protrusions, and the lower surface of the third substrate and the upper surface of the fourth substrate form a third accommodating space therebetween;
each of the plurality of conductive holes passes through the first substrate, one of the plurality of first conductive protrusions, one of the plurality of second conductive protrusions, the second substrate, one of the lower conductive protrusions, one of the upper conductive protrusions, and the third substrate, and is electrically connected to one of the plurality of third conductive protrusions; and
at least one surface of the lower surface of the third substrate and the upper surface of the fourth substrate is provided with an additional device, the plurality of conductive protrusions have a protruding height protruding from a surface where the additional device is located, the protruding height is greater than a thickness of a corresponding one of the devices, and the additional device is located in the third accommodating space.

7. The semiconductor structure according to claim 3, wherein at least one of the plurality of conductive through holes is electrically connected to a conductive pad on the upper surface of the top substrate of the uppermost unit.

8. The semiconductor structure according to any one of claims 3 to 7, wherein at least one of the plurality of conductive through holes extends through the top substrate of the uppermost unit from top to bottom, and is electrically connected to the conductive protrusions of the lowermost unit.

9. The semiconductor structure according to claim 1, wherein at least one conductive protrusion of the two conductive protrusions that are oppositely aligned with and bonded to each other has an end face, and the end face of the at least one conductive protrusion is provided with a concave-convex structure.

10. The semiconductor structure according to any one of claims 3 to 8, wherein at least one conductive protrusion of the two conductive protrusions that are oppositely aligned with and bonded to each other has an end face, and the end face of the at least one conductive protrusion is provided with a concave-convex structure; and
the concave-convex structure is arranged around a periphery of a corresponding one of the plurality of conductive through holes.

11. The semiconductor structure according to claim 1, wherein each of the conductive protrusions that are arranged on a same side of a same substrate as the device protrudes from a side of the substrate, and has a protruding height that is larger than a thickness of the device arranged on the side of the substrate.

12. The semiconductor structure according to any one of claims 1 to 11, further comprising:
a plurality of packaging rings, each of the plurality of packaging rings being arranged between two adjacent substrates, being located at an outer side of all the plurality of conductive protrusions, and being spaced apart from the plurality of conductive protrusions.

13. The semiconductor structure according to claim 12, wherein the plurality of packaging rings each comprises upper packaging protrusions and lower packaging protrusions that are metal-bonded to each other, the upper packaging protrusions are provided on a lower surface of an upper substrate of the two adjacent substrates, and the lower packaging protrusions are provided on an upper surface of a lower substrate of the two adjacent substrates.

14. The semiconductor structure according to claim 13, wherein the upper package protrusions and conductive protrusions arranged on the lower surface of the upper substrate are arranged in a same layer, are made of a same material, and have a same height; and
the lower package protrusions and conductive protrusions arranged on the upper surface of the lower substrate are arranged in a same layer, is made of a same material, and have a same height.

15. The semiconductor structure according to claim 14, wherein an end face of at least one of the upper package protrusion and the lower package protrusion that are oppositely aligned with and bonded to each other is provided with a concave-convex structure.

16. The semiconductor structure according to claim 1, wherein the substrate of the at least one unit is provided with a toothed slot or concave-convex structure, and a lower side of the corresponding conductive protrusions matches with the toothed slot or concave-convex structure.

17. The semiconductor structure according to claim 1 or 16, wherein a bonding face of at least one of the two conductive protrusions that are opposite and bonded to each other is provided with an additional toothed slot or concave-convex structure.

18. The semiconductor structure according to claim 1, wherein the semiconductor structure is a film bulk acoustic wave resonator, a film bulk acoustic wave filter, a duplexer, or a quadplexer.

19. A method of manufacturing a semiconductor structure with stacked units, the semiconductor structure comprising at least two units stacked in a thickness direction of the semiconductor structure, wherein the method comprising:
providing a first unit comprising a first substrate, the first substrate being provided with a plurality of first conductive protrusions at a first side thereof;
providing a second unit comprising a second substrate, the second substrate being provided with a plurality of second conductive protrusions at a first side thereof; and
oppositely stacking the first unit and the second unit, in such a manner that each of the plurality of first conductive protrusions is opposite and bonded to one of the plurality of second conductive protrusions,
wherein a top substrate of an uppermost unit of the at least two units and a bottom substrate of a lowermost unit of the at least two units are both packaging layers of the semiconductor structure.

20. The method according to claim 19, wherein the providing the first unit comprises providing first holes, each of the first holes passes through one of the plurality of first conductive protrusions and enters partially into the first substrate; and
the method further comprises:
thinning the first substrate from a second side of the first substrate to expose the first holes; and
forming conductive through holes by filling the first holes with a conductive material.

21. The method according to claim 20, further comprising:
forming conductive pads on the second side of the thinned first substrate, the conductive pads being arranged in one-to-one correspondence with the first holes, and each of the conductive pads being configured to be electrically connected to one of the conductive through holes.

22. The method according to claim 21, wherein the forming the conductive pads comprises:
covering each of the conductive through holes with one conductive pad of the conductive pads in such a manner that the conductive through hole is electrically connected with the one conductive through hole.

23. The method according to any one of claims 20 to 22, wherein the providing the second unit comprises providing second holes, each of the second holes passes through one of the plurality of second conductive protrusions and enters partially into the second substrate;
in the oppositely stacking the first unit and the second unit, the first holes is aligned with the second holes in one-to-one correspondence; and
the method further comprises:
thinning the second substrate from the second side of the second substrate to expose the second holes;
providing a plurality of upper conductive protrusions on the second side of the second substrate at positions corresponding to the second conductive protrusions in a thickness direction, an axis of each of the conductive through holes passing through one upper conductive protrusion of the plurality of upper conductive protrusions, and the conductive through hole being configured to be electrically connected to the one upper conductive protrusion;
providing an additional unit comprising an additional substrate, the additional substrate being provided with a plurality of lower conductive protrusions at an upper side thereof; and
oppositely stacking the additional unit and the second unit, in such a manner that each of the plurality of upper conductive protrusions is opposite and bonded to one of the plurality of lower conductive protrusions.

24. The method according to claim 23, wherein the providing the additional unit comprises:
providing a third unit, the third unit comprising a third substrate that is configured to be the additional substrate, and the third substrate being provided with a plurality of third conductive protrusions on a first side thereof.

25. The method according to claim 23, wherein the providing the additional unit comprises providing an additional set of units, and the additional set of units at least comprise a third unit and a fourth unit, wherein
the third unit comprises a third substrate and third holes, upper and lower sides of the third substrate each are provided with a plurality of third conductive protrusions, each of the third holes passes through the third substrate and one of the plurality of third conductive protrusion arranged on the upper side of the third substrate to reach or at least partially pass through one of the plurality of third conductive protrusions arranged on the lower side of the third substrate, and the plurality of third conductive protrusions arranged on the upper side of the third substrate are the plurality of lower conductive protrusions;
the fourth unit comprises a fourth substrate, the fourth substrate is provide with a plurality of fourth conductive protrusions on a first side thereof, and the plurality of fourth conductive protrusions has a protruding height greater than a thickness of the fourth device; and
the third unit and the fourth unit are oppositely stacked, and each of the plurality of fourth conductive protrusions is opposite and bonded to one of the plurality of third conductive protrusions that is arranged opposite to the fourth conductive protrusion; and the oppositely stacking the additional unit and the second unit further comprises aligning and communicating the third holes with the first holes and the second holes in one-to-one correspondence.

26. The method according to claim 25, wherein the fourth unit comprises fourth holes, and each of the fourth holes at least passes through one of the plurality of fourth conductive protrusions; and
the oppositely stacking the additional unit and the second unit further comprises aligning and communicating the first holes, the second holes, the third holes, and the fourth hole in one-to-one correspondence.

27. The method according to any one of claims 16 to 24, further comprising:
providing a plurality of packaging rings, each of the plurality of packaging rings being arranged between two adjacent substrates, being located at an outer side of all the conductive protrusions, and being spaced apart from a corresponding one of the conductive protrusions.

28. The method according to claim 27, wherein the plurality of packaging rings each comprises an upper packaging protrusion and a lower packaging protrusion that are metal-bonded to each other, the upper packaging protrusion is arranged on a lower surface of an upper substrate of the two adjacent substrates, and the lower packaging protrusion is arranged on an upper surface of a lower substrate of the two adjacent substrates; and
the conductive protrusions and the packaging protrusions of a same layer are formed simultaneously.

29. The method according to claim 28, wherein an end face of at least one of the upper protrusion and the lower protrusion that are oppositely aligned with and bonded to each other is provided with a concave-convex or toothed slot structure.

30. An electronic apparatus, comprising the semiconductor structure according to any one of claims 1 to 18 or the semiconductor structure manufactured by the method according to any one of claims 19 to 29.
